# EUROPEAN PATENT SPECIFICATION

(11) **EP 4 489 073 B1**
(45) Date of publication and mention of the grant of the patent: **10.12.2025**
(21) Application number: 24186005.5
(22) Date of filing: 02.07.2024
(51) Int. Cl.: H01L 23/498, H01L 23/64, H01L 23/50

(54) **EMBEDDED INTEGRATED STACK CAPACITOR (ISC) IN SUBSTRATE BUILD-UP LAYER**
EINGEBETTETER INTEGRIERTER STAPELKONDENSATOR (ISC) IN EINER SUBSTRATAUFBAUSCHICHT
CONDENSATEUR À EMPILEMENT INTÉGRÉ INTÉGRÉ (ISC) DANS UNE COUCHE D'ACCUMULATION DE SUBSTRAT

(30) Priority: 03.07.2023 US 202363524758 P; 20.06.2024 US 202418748662
(43) Date of publication of application: 08.01.2025
(73) Proprietor: SAMSUNG ELECTRONICS CO., LTD., Yeongtong-gu, Suwon-si, Gyeonggi-do 16677 (KR)
(72) Inventor: ZHANG, Rui, San Jose, CA, 95134 (US); KIM, Kyoungsoo, San Jose, CA, 95134 (US); KIM, WooPoung, San Jose, CA, 95134 (US)
(74) Representative: Kuhnen & Wacker Patent- und Rechtsanwaltsbüro PartG mbB

(56) References cited:
- JP-A- 2009 188 401
- JP-A- 2021 190 661
- JP-B2- 3 694 040
- US-A1- 2005 195 554
- US-A1- 2019 269 013
- MOON SUNGWOOK ET AL: "System-level Power Integrity Optimization Based on High-Density Capacitors for enabling HPC/AI applications", 2020 4TH IEEE ELECTRON DEVICES TECHNOLOGY & MANUFACTURING CONFERENCE (EDTM), IEEE, 6 April 2020 (2020-04-06), pages 1 - 4, XP033780697, DOI: 10.1109/EDTM47692.2020.9117919

## Description

### BACKGROUND

### 1. Field

This disclosure is directed to a method of embedding an integrated stack capacitor (ISC) in a substrate build-up layer and an apparatus having an ISC embedded in a substrate build-up layer.

### 2. Description of Related Art

Currently, multilayer ceramic capacitors (MLCCs) are the most produced and used capacitors in electronic devices. A substrate may have a large ceramic capacitor on a substrate surface or at a substrate core layer due to capacitor thickness limitation (e.g., > 100 µm). Due the large thickness of ceramic capacitors, these capacitors are disposed outside of a build-up layer.

A semiconductor package nay be a metal, plastic, glass, or ceramic casing containing one or more discrete semiconductor devices or integrated circuits. Individual components may be fabricated on semiconductor wafers (e.g., silicon wafers) before being diced into die, tested, and packaged as semiconductor package. The semiconductor package may have leads or contacts for devices inside of the semiconductor package.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

JP 2021 190661 A discloses the following: In a multi-layer wiring board with built-in capacitors, at least one of the capacitors is configured by providing a lower electrode, a dielectric layer, and an upper electrode in order from the one closest to a core substrate, and the lower electrode is entirely arranged on the core substrate, and the upper electrode includes a portion that constitutes the capacitor by overlapping the dielectric layer and the lower electrode, and a portion that extends from the portion that constitutes the capacitor and is arranged on the same surface as the lower electrode, and the upper electrode includes a terminal portion provided on the portion arranged on the same surface as the lower electrode. The material of the core substrate is glass.

JP 3 694040 B2 discloses the following: A multilayer board comprising a laminate of a plurality of dielectric layers incorporates a strip line conductor, a GND electrode and a plurality of capacitors, the GND electrodes are disposed on the opposite sides of the strip line conductor in the laminating direction to constitute a triplate type strip line resonator. In such a high frequency module, the triplate type strip line resonator is set in a substantially central part of the multilayer board in the laminating direction. A high frequency short- circuiting capacitor is disposed on the underside of the triplate type strip line resonator in the laminating direction and other capacitors are disposed on the upper side.

US 2019/269013 A1 discloses the following: An electronic component includes a glass base in which through holes are formed passing through both surfaces thereof; an insulating resin layer laminated on each of both surfaces of the glass base and including a copper plated layer formed therein; and a capacitor including a lower electrode formed on the copper plated layer, a dielectric layer laminated on the lower electrode, and an upper electrode laminated on the dielectric layer. In the electronic component, the upper electrode has a region that is parallel to the copper plated layer and is formed so as to be smaller than a region of the dielectric layer parallel to the surface of the copper plated layer or a region of the lower electrode parallel to the surface of the copper plated layer.

JP 2009 188 401 A discloses the following: In the printed circuit board with built-in capacitor, the capacitor has a dielectric, one electrode with a relatively smaller area in comparison with that of the dielectric, and another electrode with the relatively larger area in comparison with that of the dielectric.

MOON SUNGWOOK ET AL: "System-level Power Integrity Optimization Based on High-Density Capacitors for enabling HPC/AI applications", 2020 4TH IEEE ELECTRON DEVICES TECHNOLOGY & MANUFACTURING CONFERENCE (EDTM), IEEE, 6 April 2020 (2020-04-06), pages 1-4, XP033780697, DOI: 10.1109/EDTM47692.2020.9117919 discloses the following: In this work, we introduce platform-level power integrity (PI) solutions to enable high-power core IPs and high bandwidth memory (HBM) interface for HPC/AI applications. High-complexity design methodology becomes more significant to enable high-power operations of CPU/GPU/NPU that preforms iteratively tremendous computing processes. In order to achieve high-power performance at larger than 200W class, system-level PI analysis and design guide at early design stage is required to prevent drastic voltage variations at the bump under comprehensive environments including SoC, interposer, package and board characteristics. PI solutions based on high density on-die capacitors are suitable for mitigating voltage fluctuations by supplying quickly stored charges to silicon devices. In adopting 2-/3-plate metal-insulator-metal (MIM) capacitor with approximately 20nF/mm2 and 40nF/mm2, and integrated stacked capacitor (ISC) with approximately 300nF/mm2, it is demonstrated that voltage properties (drop and ripple) are able to be improved by system-level design optimization such as power delivery network (PDN) design and RTL-architecture manipulation. Consequently, system-level PI solutions based on high-density capacitor are anticipated to contribute to improving target performance of high-power products in response to customer's expectation for HPC/AI applications.

### SUMMARY

The invention is set out in the appended claims.

According to one or more embodiments, a semiconductor package comprises a core layer. The semiconductor package further comprises a capacitor, e.g. an integrated stack capacitor (ISC), on the core layer. The semiconductor package comprises one or more build-up layers on the core layer, wherein the capacitor is embedded in the one or more build-up layers. The semiconductor package comprises one or more metal layers on the core layer.

The embodiments of the present disclosure provide improved dielectric thickness uniformity. A thickness of the capacitor in the build-up layer matches a thickness of the at least one metal layer embedded in a same build-up layer, thereby enabling the capacitor to be used as a filler (e.g., dummy silicon) in areas of a semiconductor package where it is not possible to form or place copper. As a result, the embodiments of the present disclosure improve a mechanical strength of the semiconductor package dielectric thickness uniformity.

### BRIEF DESCRIPTION OF DRAWINGS

Further features, the nature, and various advantages of the disclosed subject matter will be more apparent from the following detailed description and the accompanying drawings in which:
FIG. 1 is a schematic illustration of an example semiconductor package.
FIG. 2 is an illustration of a process of forming a semiconductor package with an integrated stack capacitor (ISC) embedded in a build-up layer, in accordance with embodiments of the present disclosure.
FIG. 3 is a schematic illustration of a build-up layer with a copper wiring pattern and an ISC embedded therein, in accordance with embodiments of the present disclosure.
FIG. 4 is an illustration of a process of forming a semiconductor package with an ISC embedded in a build-up layer, in accordance with embodiments of the present disclosure.
FIG. 5 is a schematic illustration of a build-up layer with a copper wiring pattern and an ISC embedded therein, in accordance with embodiments of the present disclosure.
FIG. 6 is a schematic illustration of a semiconductor package with one or more ISCs embedded in one or more build-up layers, in accordance with embodiments of the present disclosure.
FIG. 7 is a schematic illustration of a semiconductor package with one or more ISCs embedded in one or more layers, in accordance with embodiments of the present disclosure.
FIG. 8 is a schematic illustration of a build-up layer with a copper wiring pattern and an ISC embedded therein with one or more terminal contacts, in accordance with embodiments of the present disclosure.
FIG. 9 is a schematic illustration of a build-up layer with an active ISC and a non-active ISC, in accordance with embodiments of the present disclosure.
FIG. 10 is a flow chart of a process of forming a semiconductor package with an ISC embedded in a build-up layer.
FIG. 11 is a schematic diagram illustrating an electronic device including at least semiconductor package shown in FIG. 6 or 7, in according with embodiments of the present disclosure.

### DETAILED DESCRIPTION

The following detailed description of example embodiments refers to the accompanying drawings. The same reference numbers in different drawings may identify the same or similar elements.

The foregoing disclosure provides illustration and description, but is not intended to be exhaustive or to limit the implementations to the precise form disclosed. Modifications and variations are possible in light of the above disclosure or may be acquired from practice of the implementations. Further, one or more features or components of one embodiment may be incorporated into or combined with another embodiment (or one or more features of another embodiment). Additionally, in the flowcharts and descriptions of operations provided below, it is understood that one or more operations may be omitted, one or more operations may be added, one or more operations may be performed simultaneously (at least in part), and the order of one or more operations may be switched.

It will be apparent that systems and/or methods, described herein, may be implemented in different forms of hardware or firmware. The actual specialized control hardware used to implement these systems and/or methods is not limiting of the implementations.

Even though particular combinations of features are recited in the claims and/or disclosed in the specification, these combinations are not intended to limit the disclosure of possible implementations. In fact, many of these features may be combined in ways not specifically recited in the claims and/or disclosed in the specification. Although each dependent claim listed below may directly depend on only one claim, the disclosure of possible implementations includes each dependent claim in combination with every other claim in the claim set.

No element, act, or instruction used herein should be construed as critical or essential unless explicitly described as such. Also, as used herein, the articles "a" and "an" are intended to include one or more items, and may be used interchangeably with "one or more." Where only one item is intended, the term "one" or similar language is used. Also, as used herein, the terms "has," "have," "having," "include," "including," or the like are intended to be open-ended terms. Further, the phrase "based on" is intended to mean "based, at least in part, on" unless explicitly stated otherwise. Furthermore, expressions such as "at least one of [A] and [B]" or "at least one of [A] or [B]" are to be understood as including only A, only B, or both A and B.

Reference throughout this specification to "one embodiment," "an embodiment," or similar language means that a particular feature, structure, or characteristic described in connection with the indicated embodiment is included in at least one embodiment of the present solution. Thus, the phrases "in one embodiment", "in an embodiment," and similar language throughout this specification may, but do not necessarily, all refer to the same embodiment.

Furthermore, the described features, advantages, and characteristics of the present disclosure may be combined in any suitable manner in one or more embodiments. One skilled in the relevant art will recognize, in light of the description herein, that the present disclosure may be practiced without one or more of the specific features or advantages of a particular embodiment. In other instances, additional features and advantages may be recognized in certain embodiments that may not be present in all embodiments of the present disclosure.

Herein, the term "connection" between two structures or elements may refer to electrical connection therebetween. For example, connection between semiconductor chips, semiconductor packages, and/or semiconductor devices may refer to electrical connection of corresponding two or more elements to each other. The terms "coupled" and "connected" may have the same meaning and used interchangeably herein. Further, the term "isolation" between two structures or elements pertains to electrical insulation or separation therebetween. For example, isolation of wiring patterns from each other may mean that the wiring patterns are not electrically connected to each other.

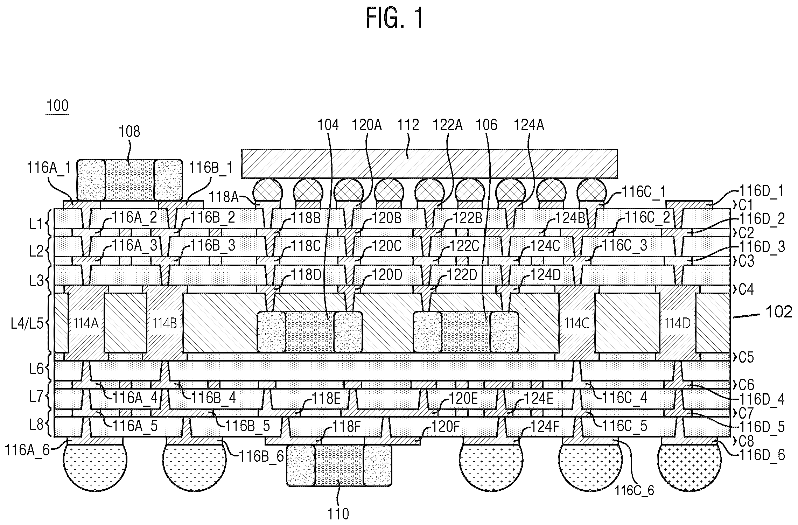

Herebelow, various embodiments of the disclosure are described in reference to FIGS. 1-11.

Integrated stack capacitor (ISC) technology is a new emerging technology using a silicon dynamic random access memory (DRAM) cell cap process to enable a silicon-based capacitor having a high capacitance density. The ISC technology is at a very early stage. The most common application of the ISC technology is to integrate an ISC in a silicon fabrication process (e.g., building an ISC inside a logic chip). Another application is to build an ISC on a silicon wafer, and later singulate (e.g., dice) the wafer into one or more discrete components. However, current manufacturing of semiconductor packages and electronic devices do not take advantage of a size advantage of ISCs over ceramic capacitors.

Embodiments of the present disclosure are directed to forming a semiconductor package in which an integrated stack capacitor (ISC) is embedded in a substrate build-up layer in the semiconductor package. The substrate build-up layer may be an organic layer. The substrate build-up layer may have a thickness of 15-45 µm. According to one or more embodiments, the ISC may be embedded in the substrate build-up layer during a substrate manufacturing process.

In one or more examples, a build-up layer may be formed of one more build-up films. The multiple layers of build-up films may serve the purposes of fanning out a small bump pitch from a chip to the much larger bump pitch of the solder ball used to connect the substrate to the printed circuit board. Build-up layer provide high interconnect density between a chip to a substrate.

Build-up layers may be defined by width, thickness, and spacing. In one or more examples, the majority of signal wiring may be included in the build-up layers. The build-up layers may further be characterized by dielectric characteristics, thickness, electrical properties such as dielectric constant and loss tangent, and thermal expansion characteristics.

The build-up layers may contain one or more vias. The vias may be formed by drilling through a single dielectric layer at a time. In one or more examples, the vias may be stair-stepped ascending through the build-up layers. In one or more examples, the vias may be stacked in the build-up layers.

Build-up layers can be fabricated on one or both sides of the package core. In some cases, there may be the same number of buildup layers on both sides of the package core. In other cases, the buildup layers formed on either side of the package core may be asymmetric. The stack can also be asymmetric with different layer thicknesses on either side of the core. In one or more examples, the core of the semiconductor package may have a plurality of through holes for making electrical connections from one side of the core to the other side of the core. Thus, the vias in the core may allow one or more build-up layers on the top end of the semiconductor package to be electrically connected to one or more build-up layers on the bottom end of the semiconductor package.

The build-up layers may be formed of dielectric material. Each build-up layer may be formed of the same dielectric material. In one or more examples, the build-up layers may be formed of different dielectric materials. For example, a first build-up layer may be formed of a low-k dielectric material, and a second build-up layer may be formed of a high-k dielectric material. Examples of low-k dielectric materials include, but are not limited to, fluorine-doped silicon dioxide, organosilicate glass (OSG), carbon-doped oxide (CDO), porous silicon dioxide, porous organosilicate glass, spin-on organic polymeric dielectrics, spin-on silicon based polymeric dielectric. Examples of high-k dielectric materials include, but are not limited to, hafnium silicate, zirconium silicate, hafnium dioxide and zirconium dioxide.

In one or more examples, the build-up layers may be formed of at least one dielectric layer and one metallic layer. In one or more examples, the dielectric layer and the metallic layer may have the same thickness. In one or more examples, the thickness of the dielectric layer may be thicker than the thickness of the metallic layer. For example, the thickness of the dielectric layer may range from 50% - 70% of the thickness of a build-up layer, where the metallic layer may form the remaining thickness of the dielectric layer.

In the embodiments of the present disclosure, the terms "copper layer" may refer to a copper wiring pattern, a copper trace connection, or copper via, or a copper terminal contact.

The embodiments of the present disclosure may include an ISC. The ISC exhibits high capacitance density compared to conventional silicon capacitors. The ISC may include at least one stack capacitor. In one or more examples, the ISC may be a vertical cylinder array comprising one or more capacitive vias. The stack capacitor may comprise a plurality of planar capacitors arranged in layers on each other, with electrodes thereof connected in parallel. Stacked capacitors may include, for example, crown-stacked capacitors, raw silicon stacked capacitors, or any other suitable capacitor known to one of ordinary skill in the art. The ISC may be manufactured by any suitable stack capacitor forming process known to one of ordinary skill in the art. FIG. 1 illustrates an example semiconductor package 100. The semiconductor package 100 may include a core layer 102, ceramic capacitors 104, 106, 108, and 110, and a silicon backplane 112. In one or more examples, the silicon backplane may be another integrated circuit or a display. The ceramic capacitor 108 may be attached to a package front side as a die side capacitor (DSC) using a surface mount technology (SMT) process. In one or more examples, the ceramic capacitor 110 may be attached to a package bottom side as a land side capacitor (LSC).

The ceramic capacitors 104 and 106 may be embedded in the core layer 102, which may be a copper clad laminate (CCL) core. The semiconductor package 100 may include one or more build-up layers subsequently added after the core layer 102 is added. The core layer thickness may range from 100 µm to 800 µm, and a thickness of one build-up layer, which may be referred to as a dielectric thickness, may range from 20 µm to 45 µm. The substrate 100 may be a 3-2-3 structure with a two-layer core and six build-up layers resulting in eight layers in total. For example, as illustrated in FIG. 1, layer L4/L5 constitutes the core 102, layers L1-L3 constitute the build-up layers above the core layer 102, and layers L6-L8 constitute the build-up layers below the core layer 102. In one or more examples, each of layers L1-L3 and L6-L8 may have the same thickness. In one or more examples, The L4/L5 layer that constitutes the core may have a thickness that is twice the thickness of one build-up layer. In one or more examples, the L4/L5 layer may have a thickness that is equal to the thickness of build-up layers L1-L3 combined, or the thickness of layers L6-L8 combined.

In one or more examples, the semiconductor package 100 may include copper vias 114A, 114B, 114C and 114D. Each of the copper vias may be connected to copper wiring patterns through the build-up layers. For example, the copper via 114 may be connected to the copper wiring patterns 116A_1-116A_6 through the build-up layers L1-L6. In one or more examples, each copper wiring pattern may include a flat portion and a protrusion portion perpendicular to the flat portion and inserted in or penetrating a build-up layer. For example, the copper wiring pattern 116A_1 may include a protrusion portion in layer L1 that connects copper wiring pattern 116A_1 to the copper wiring pattern 116A_2.

The copper via 114B may be connected to the copper wiring patterns 116B_1-116B_6 through the build-up layers L1-L6. The copper via 114C may be connected to the copper wiring patterns 116C_1-116C_6 through the build-up layers L1-L6. The copper via 114D may be connected to the copper wiring patterns 116D _1-116D_6 through the build-up layers L1-L6.

The ceramic capacitors 104, 106, 108 and 110 may also be connected to some of the copper wiring patterns through some of the build-up layers. For example, the ceramic capacitor 104 may be connected to a first set of copper wiring patterns 118A, 118B, 118C and 118D, and a second set of copper wiring patterns 120A, 120B, 120C and 120D through the build-up layers L1-L3. Similarly, the ceramic capacitor 106 may be connected to a third set of copper wiring patterns 122A, 122B, 122C and 122D, and a fourth set of copper wiring patterns 124A, 124B, 124C, and 124D through the build-up layers L1-L3. The ceramic capacitor 108 may be connected to the via 114A through the copper wiring patterns 116A_1, 116A_2, and 116A_3. The ceramic capacitor 108 may be further connected to the via 114B through the copper wiring patterns 116B_1, 116B_2, and 116B_3. The ceramic capacitor 110 may be connected to the copper wiring patterns 118E and 118F and copper wiring patterns 120E and 120F through the build-up layers L5 and L6. The semiconductor package 100 may further include additional copper wiring patterns 124E and 124F for various other connections.

The dielectric thickness and the core layer thickness of the semiconductor package 100 may be specified as follows in Table 1. As illustrated in Table 1, the core layer 102 may be two layers (e.g., L4 and L5).

**Table 1**

| Layers | Thickness |
|---|---|
| L1 | 20 - 45 µm |
| L2 | 20 - 45 µm |
| L3 | 20 - 45 µm |
| L4/L5 | 100 - 800 µm |
| L6 | 20 - 45 µm |
| L7 | 20 - 45 µm |
| L8 | 20 - 45 µm |

A copper layer thickness of a flat portion of a copper wiring pattern may be specified as one of C1-C3 and C6-C8. The flat portion of the copper wiring pattern may be perpendicular to a protrusion portion of the copper wiring pattern. For example, the thickness C1 may correspond to a copper layer thickness of a flat portion of the copper wiring patterns 116A_1, 116B_1, 116C_1, 116D_1, 118A, 120A, 122A, 122A, and 124A. The thickness C2 may correspond to a copper layer thickness of a flat portion of the copper wiring patterns 116A_2, 116B_2, 116C_2, 116D_2, 118B, 120B, 122B, and 124B. The thickness C3 may correspond to a copper layer thickness of a flat portion of the copper wiring patterns 116A_3, 116B_3, 116C_3, 116D_3, 118C, 120C, 122C, and 124C. The thickness C6 may correspond to a copper layer thickness of a flat portion of the copper wiring patterns 116A_4, 116B_4, 116C_4, and 116D_4. The thickness C7 may correspond to a copper layer thickness of a flat portion of the copper wiring patterns 116A_5, 116B_5, 116C_5, 116D_5, 118B, 120E, and 124E. The thickness C8 may correspond to a copper layer thickness of a flat portion of the copper wiring patterns 116A_6, 116B_6, 116C_6, 116D_6, 118F, 120F, and 124F.

The thicknesses C4 and C5 may correspond to thicknesses of a top flat portion and a bottom flat portion, respectively, of each of the copper vias 114A-114D. The copper layer thicknesses C1-C8 may be specified as follows in Table 2.

**Table 2**

| Layers | Thickness |
|---|---|
| C1 | 10 - 25 µm |
| C2 | 10 - 25 µm |
| C3 | 10 - 25 µm |
| C4 | 25 - 45 µm |
| C5 | 25 - 45 µm |
| C6 | 10 - 25 µm |
| C7 | 10 - 25 µm |
| C8 | 10 - 25 µm |

Currently, a ceramic capacitor is embedded in a core layer due to thickness limitations. For example, a ceramic capacitor generally has a thickness usually greater than 100 µm, and thus, is generally not included in a build-up layer. Embedding a ceramic capacitor in a core layer requires additional manufacturing processes, and only has a few applications due to manufacturing costs. Although a process to embed a ceramic capacitor into a build-up layer may be performed, this type of process requires removal of multiple build-up layers to create a space to embed the ceramic capacitor therein, which is very complicated and significantly drives up the costs of manufacturing.

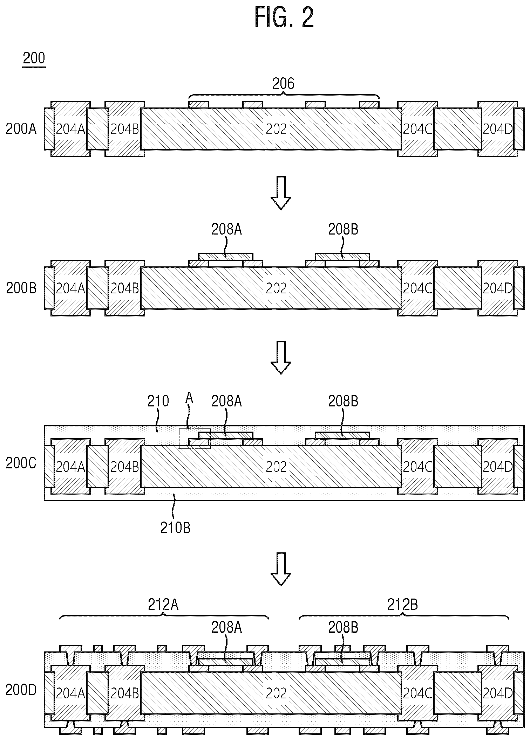

FIG. 2 is an illustration of a process 200 of forming a semiconductor package with an ISC embedded in a build-up layer, in accordance with embodiments of the present disclosure. In operation 200A, a core layer 202 may be formed. The core layer 202 may be a CCL layer. In one or more examples, the core layer 202 may be drilled via mechanical drilling to form through holes, which may be filled with copper to form copper vias 204A, 204B, 204C, and 204D. The copper vias 204A-204D may be the same as or correspond to copper vias 114A-114D, respectively, shown in FIG. 1. Furthermore, in one or more examples, copper wiring patterns 206 may be formed on the core layer 102.

In operation 200B, one or more ISCs may be formed on the copper wiring patterns 206. For example, as illustrated in FIG. 2, ISCs 208A and 208B are formed on the copper wiring patterns 206. As illustrated in FIG. 2, a back surface of each of the ISCs 208A and 208B is in direct contact with top surfaces of the copper wiring patterns 206. Accordingly, an electrical connection may be established between the copper wiring patterns 206 and each of the ISC 208A and the ISC 208B.

In operation 200C, a build-up layer may be formed on the core layer such that one or more ISCs are embedded in the build-up layer. For example, as illustrated in FIG. 2, a build-up layer 210 is formed on the core layer 202 such that the ISC 208A and the ISC 208B are embedded in the build-up layer 210. The build-up layer 210 may be formed through, for example, a film lamination process.

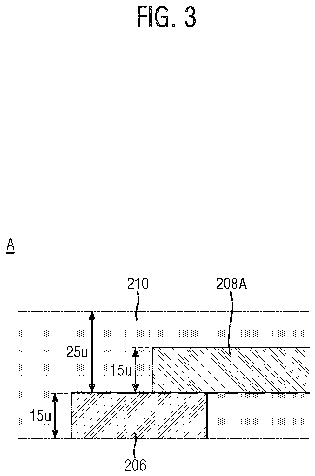

FIG. 3 is an enlarged view of a portion A shown in FIG. 2, which is a schematic illustration of the build-up layer 210 with at least a portion of the copper wiring patterns 206 and the ISC 208A embedded in the build-up layer 210. In one or more examples, a thickness of the ISC 208 may be equal or substantially equal (e.g., within ±5%) to a thickness of the copper wiring pattern 206. For example, as illustrated in FIG. 3, the thickness of both the ISC 208 and the copper wiring pattern 206 is 15 µm. In one or more examples, a thickness of the build-up layer 210 is greater than a combination of the thickness of the copper wiring pattern 206 and the ISC 208A. For example, as illustrated in FIG. 3, the thickness of the build-up layer 210 is 40 µm. As understood by one or ordinary skill in the art, the thickness of the ISC 208 and the thickness of the copper wiring pattern 206 may be different from each other.

In operation 200D, copper wiring patterns 212A and 212B may be formed. The copper wiring patterns 212A and 212B may be formed through, for example, laser drilling to form through holes through the build-up layer 210. The through holes may be filled with copper to establish an electrical connection with the copper vias 204A-204D, the copper wiring pattern 206, and/or the ISCs 208A and 208B.

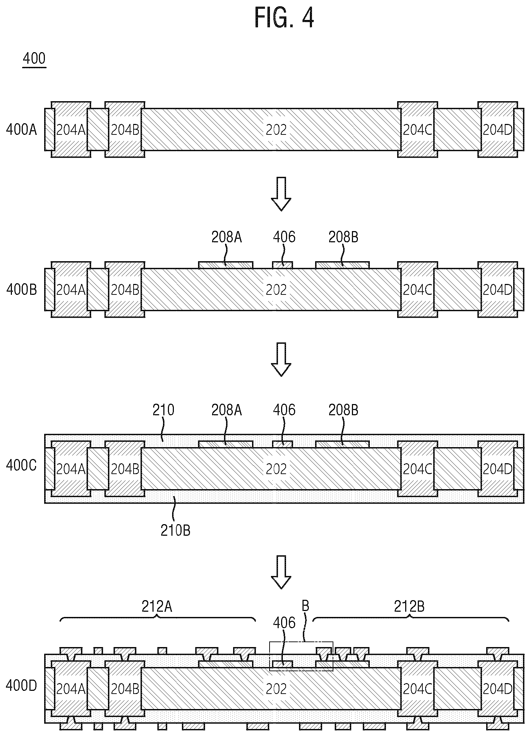

FIG. 4 is an illustration of a process 400 of forming a semiconductor package with an ISC embedded in a build-up layer, in accordance with embodiments of the present disclosure.

In operation 400A, a core layer 202 may be formed. The core layer 202 may be the same as or correspond to the core layer 202 formed in operation 200A (FIG. 2) in which copper vias 204A-204D are formed. The copper vias 204A-204D may be the same or correspond to the copper vias 104A-104D in FIG. 1, respectively.

In operation 400B, ISCs may be formed on the core layer 202 such as ISCs 208A and 208B, which may be the same as or correspond to the ISCs 208A and 208B in FIG. 2, respectively. With respect to the process 200 in FIG. 2, the process 400 forms the ISCs 208A and 208B directly on a top surface of the core layer 202 such that back surfaces of the ISCs 208A and 208B are in direct contact with a top surface of the core layer 202. In operation 400B, a copper wiring pattern including a copper wiring pattern 406 may be formed.

In operation 400C, a build-up layer may be formed in a similar manner as described above for operation 200C. For example, a build-up layer 210 in FIG. 4 may be the same as or correspond to the build-up layer 210 in FIG. 2.

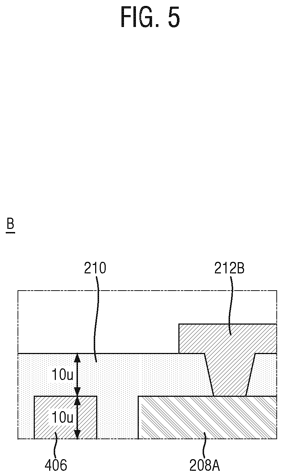

FIG. 5 is an enlarged view of a portion B shown in FIG. 4, which is a schematic illustration of the build-up layer 210 with a copper wiring pattern 406 and the ISC 208 embedded in the build-up layer 210, in accordance with embodiments of the present disclosure. In one or more examples, a thickness of the ISC 208 may be equal or substantially equal (e.g., within ±5%) to a thickness of the copper wiring pattern 406. For example, as illustrated in FIG. 5, the thickness of each of the ISC 208 and the copper wiring pattern 406 is 10 µm. In one or more examples, a thickness of the build-up layer 210 is greater than the thickness of each of the copper wiring pattern 406 and the ISC 208A. For example, as illustrated in FIG. 5, the thickness of the build-up layer 210 is 20 µm. As understood by one or ordinary skill in the art, the thickness of the ISC 208 and the thickness of the copper wiring pattern 406 may be different from each other.

In operation 400D, copper wiring patterns 212A and 212B may be formed in a similar manner as described above for operation 200D.

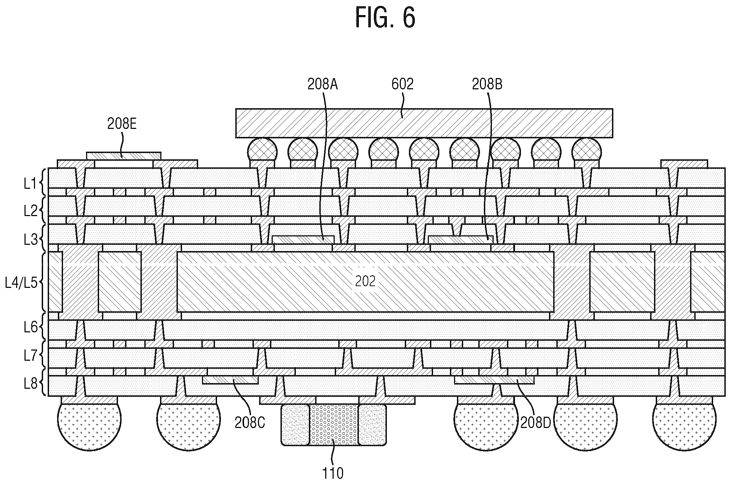

FIG. 6 is a schematic illustration of a semiconductor package 600 with one or more ISCs embedded in one or more build-up layers, in accordance with embodiments of the present disclosure. The semiconductor package 600 may be incorporated into a semiconductor device such as an electronic device (e.g., handheld device, computer, tablet, etc.). The semiconductor device may include a printed circuit board (PCB) that includes the semiconductor package 600 and one or more integrated circuits coupled to the semiconductor package 600.

The semiconductor package 600 may be a 3-2-3 structure with a two-layer core 202 and six build-up layers resulting in eight layers in total. For example, as illustrated in FIG. 6, layers L4 and L5 constitute a core 202, layers L1-L3 constitute build-up layers above the core layer 202, and layers L6-L8 constitute build-up layers below the core layer 202. The semiconductor package 600 may include a silicon backplane 602 as a base structure. Although not indicated by reference numbers, the semiconductor package 600 may also include the same copper vias 114A-114D, and copper wiring patterns 116A _1-116A 6, 116B_1-116B_6, 116C_1-116C_6, 116D_1-116D_6, 118A-118F, 120A-120F, 122A-122F, and 124A-124F. Duplicate descriptions thereof are omitted herein.

The semiconductor package 600 may include ISCs 208A and 208B embedded in a build-up layer L3, and ISCs 208C and 208D embedded in a build-up layer L8. The ISCs 208A-208D may be formed in accordance with process 200 (FIG. 2) in which an ISC is formed on a copper wiring pattern and embedded in a build-up layer. Furthermore, as illustrated in FIG. 6, the semiconductor package 600 may include an additional ISC 208C and a ceramic capacitor 110 formed outside of the build-up layers. The dielectric thickness of the layers for the semiconductor package 600 may be in accordance with Table 1. The copper layer thickness of the layers for the semiconductor package 600 may be in accordance with Table 2.

According to one or more embodiments, the ISC may take a form of a vertical cylinder array including a plurality of capacitive vias between two or more connection terminals, and have a very low profile, for example, about 2.0 × 2.0 × 2.0 µm, while a DSC or a LSC, which may be a multilayer ceramic capacitor (MLCC), has a size of hundreds of micrometers (µm), for example, about 1.0 × 0.5 × 0.35 mm for the 0402 MLCC. The ISC may have a high capacitance density similar to that of the MLCC. For example, the ISC may have hundreds of nF/mm² capacitance values, e.g., 1100 nF/mm2.

The semiconductor package 600 takes advantage of a thickness of the ISC which is about 2 µm. In one or more examples, the ISC thickness may be between 2µm to 700 µm with the silicon backplane 602 as the base structure. With the thickness of the ISC less than the dielectric thickness (e.g., the thickness of a build-up layer), the ISC may be advantageously placed at any build-up layer without requiring a complicated process of removing a dielectric material. The ISC may also be placed as a DSC component or an LSC component at a surface layer in accordance with an SMT process known to one of ordinary skill in the art. In one or more examples, no additional Capex investment is needed. In one or more examples, the ISC thickness may be designed to match a thickness of a copper wiring pattern that is embedded in a same build-up layer as the ISC. In one or more examples, the ISC may also be modified to have more than two terminals, which improves circuit design and advantageously reduces a substrate footprint.

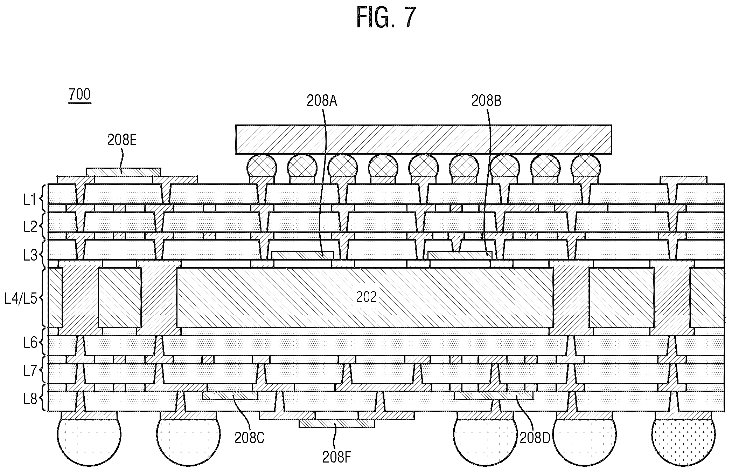

FIG. 7 is a schematic illustration of a semiconductor package 700 with one or more ISCs embedded in one or more layers, in accordance with embodiments of the present disclosure. The semiconductor package 700 may be the same as or similar to the semiconductor package 600 except that the ceramic capacitor 110 is replaced with an ISC 208F. Thus, duplicate descriptions thereof are omitted herein. The dielectric thickness of the layers for the semiconductor package 700 may be in accordance with Table 1. The copper thickness of the layers for the semiconductor package 700 may be in accordance with Table 2.

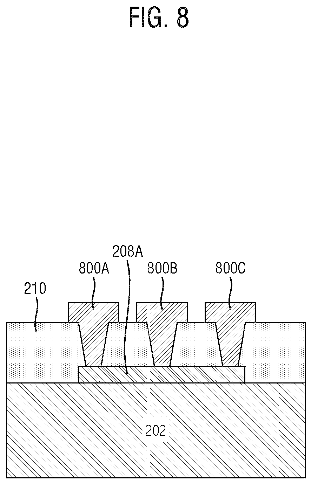

FIG. 8 is a schematic illustration of a build-up layer with a copper layer and an ISC embedded therein with one or more terminal contacts, in accordance with embodiments of the present disclosure. For example, as illustrated in FIG. 8, an ISC 208A may be in electrical connection with terminal contacts 800A, 800B, and 800C. The terminal contacts 800A-800C may be formed through, for example, laser drilling to form through holes in a build-up layer 210. The through holes may be filled with copper to form the terminal contacts 800A-800C. Although three terminal contacts are illustrated in FIG. 8, as understood by one of ordinary skill in the art, the ISC 208A may be electrically connected to more than three terminal contacts. The terminal contacts may be made of copper, and may be referred to as copper terminal contacts.

As understood by one of ordinary skill in the art, dielectric thickness uniformity is a pertinent issue for high end substrates. In this regard, as the substrate size continues getting bigger and the dielectric layer continues getting thinner, the thickness uniformity issue becomes more and more challenging. Specifically, a mechanism of dielectric material melt and flow during lamination processing presents disadvantages. As understood by one of ordinary skill in the art, an area with a high copper density (e.g., copper plane) tends to hold more material, whereas at a low copper density area, dielectric material tends to flow away, resulting in a lower dielectric thickness. A high copper density (e.g., a continuous copper plane) is preferred, but not possible due to design/electrical requirements. Furthermore, another issue with copper density non-uniformity is a resulting substrate warpage. In one or more examples, a non-active ISC may be used as a mechanical filler to help increase pseudo copper density, thereby improving dielectric thickness uniformity and helping mitigation of substrate warpage.

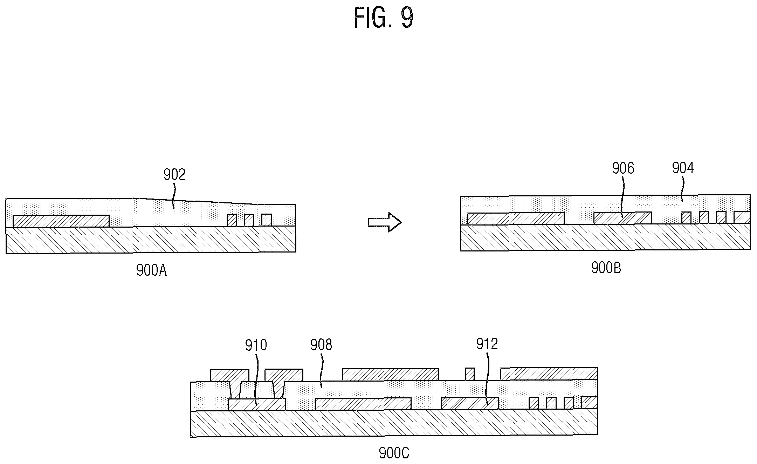

FIG. 9 is a schematic illustration of a build-up layer with an active ISC and a non-active ISC, in accordance with embodiments of the present disclosure. As illustrated in FIG. 9, a semiconductor package 900A has a build-up layer 902 with a non-uniform dielectric thickness. The semiconductor package 900B includes a build-up layer 904 with one or more non-active ISCs 906 to achieve dielectric thickness uniformity. In one or more examples, a semiconductor package may include both an active ISC and a non-active ISC to achieve dielectric thickness uniformity. For example, the semiconductor package 900C includes a build-up layer 908 with at least one active ISC 910 and at least one non-active ISC 912. As illustrated in FIG. 9, semiconductor package 900C includes a uniform dielectric thickness. In one or more examples, a non-active ISC may be placed at a same time as an active ISC. In one or more examples, the non-active ISC may be formed in accordance with process 200 (FIG. 2) or process 400 (FIG. 4). As understood by one of ordinary skill in the art, a non-active ISC may be an ISC that is not configured to store or distribute electrical energy.

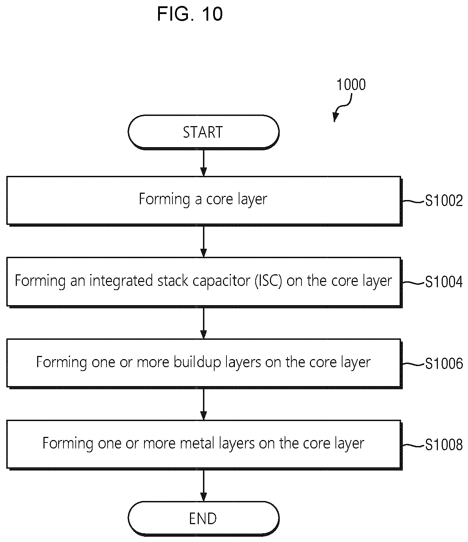

FIG. 10 is a flow chart of a process 1000 of forming a semiconductor package with an ISC embedded in a build-up layer. The process 1000 may be used to form the semiconductor package 600 (FIG. 6) or the semiconductor package 700 (FIG. 7).

The process may start at operation S1002 where a core layer is formed. For example, a core layer may be formed in accordance with operation 200A (FIG. 2) or 400A (FIG. 4).

The process may proceed to operation S1004 where an ISC is formed on the core layer. For example, the ISCs 208A and 208B may be formed on the core layer 202 in accordance with operation 200B (FIG. 2) or 400B (FIG. 4).

The process may proceed to operation S1006 where one or more build-up layers are formed on the core layer. For example, the build-up layer 210 may be formed on the core layer 202 in accordance with operation 200C (FIG. 2) or 400C (FIG. 4) where the ISCs 208A and 208B are embedded therein.

The process may proceed to operation S1008 where one or more metal layers are formed on the core layer. For example, the one or more metal layers may include the copper wiring patterns 212A and 212B formed on the core layer 202 in accordance with operation 200D (FIG. 2). In another example, the one or more copper layers may include the copper wiring 406 formed on the core layer 202 in accordance with operation 400D (FIG. 4).

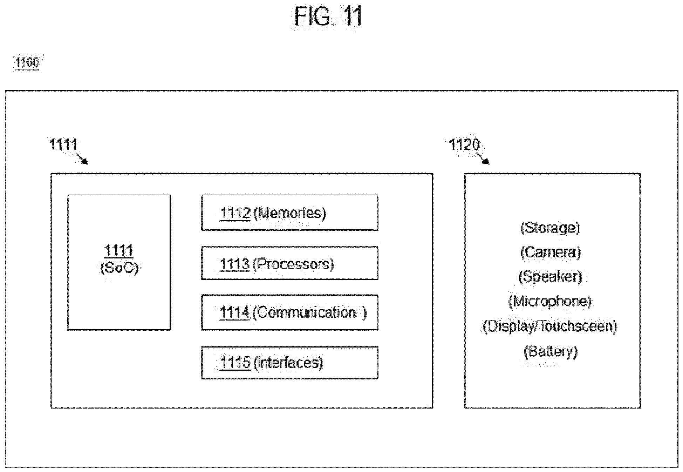

FIG. 11 is a schematic diagram illustrating an electronic device including at least semiconductor package shown in FIG. 6 or 7, in according with embodiments of the present disclosure.

Referring to FIG. 11, an electronic device 1100 may include a printed circuit board (PCB) or motherboard 1110 on which a plurality of semiconductor packages 1111-1115 are mounted. The electronic device 1100 may also include a plurality of other components 1120.

The semiconductor package 1111 may include an SoC which may include at least one of a CPU, a GPU, an AI module, a modem, one or more memory units, a power management unit, etc. to control overall operations of the electronic device 1100. The other semiconductor packages 1112-1115 may include memory chips, various other processor chips, communication chips and interface chips, respectively. The communication chips included in the semiconductor package 1114 may be configured to also perform wireless or wire communication functions in association with the SoC. At least one of the semiconductor packages 1111-1115 may be implemented by the semiconductor package shown in FIG. 6 or 7.

The other components 1120 included in the electronic device 100 may include a storage, a camera module, a speaker, a microphone, a display, a battery, etc. The storage may be configured to store user data. The storage may be an embedded multimedia card (eMMC), a solid state drive (SSD), a universal flash storage (UFS) device, etc. The display may be implemented to display data processed by the SoC and/or to receive data through a touchscreen panel of the display.

The foregoing is illustrative of exemplary embodiments and is not to be construed as limiting the disclosure. Although a few exemplary embodiments have been described, those skilled in the art will readily appreciate that many modifications are possible in the above embodiments without materially departing from the disclosure.

The embodiments of the present disclosure provide significant advantageous features including space saving, performance improvement (e.g., electrical performance and mechanical performance), manufacturing yield improvement, etc. In one or more examples the embodiments of the present disclosure provide space saving for a substrate surface area by embedding an ISC in a build-up layer, whereas in contrast, a ceramic capacitor can only be placed on a surface as a DSC component or a LSC component.

The embodiments of the present disclosure may result in improved electrical performance. For example, an ISC provides better electrical performance (e.g., higher capacitance density) than a ceramic capacitor on a surface.

The embodiments of the present disclosure may result in a simplified packaging/assembly process (e.g., a capacitor already placed during a substrate manufacturing process), where there is no need for additional component placement during assembly.

The embodiments of the present disclosure may result in a semiconductor package or an electronic device that is mechanically more robust. For example, the embodiments of the present disclosure do not require a solder joint, thereby eliminating the risk of a solder joint crack. An ISC to copper trace connection may be formed by a normal copper plating process, thereby eliminating the soldering process used in a DSC process or a LSC process, which also requires a cleaning or deflux process. Therefore, the embedded ISC in accordance with the embodiments of the present disclosure is more environmentally friendly compared with a normal DSC or LSC which uses an SMT process involving solder and chemical cleaning.

The embodiments of the present disclosure may result in an elimination of contamination risk due to flux or underfill material overflow. The underfill material (e.g., epoxy material) may be required after silicon attachment, and the underfill material could overflow to contaminate a DSC component around a silicon chip. A very tight design rule and process control is required to avoid these disadvantages. By using an embedded ISC in accordance with the embodiments of the present disclosure, a surface component (e.g., DSC) is no longer needed, thereby eliminating the need to use underfill.

The embodiments of the present disclosure may result in enabling an electrical test to be performed at a substrate level instead of waiting after die/components are all attached. Conventionally, a DSC test or a LSC test is performed post assembly where expensive silicon is already attached to a semiconductor package. As a result, the conventional DSC testing and LSC testing is more expensive than the testing performed for the embodiments of the present disclosure.

The embodiments of the present disclosure may enable an ISC to be used as a filler to balance copper density.

The embodiments of the present disclosure may result in a reduced surface area, thereby leading to advantageous space savings. Furthermore, multiple ISCs may be placed in the same layer.

The embodiments of the present disclosure may result in an electrical benefit where the ISC is closer to silicon.

The embodiments of the present disclosure may result in yield improvement since embedding an ISC in a build-up layer may be performed inside a substrate manufacturing facility, which is cleaner (e.g., better particle control) than an assembly factory. As a result, foreign material induced failure is reduced, thereby enhancing product quality and reliability.

The embodiments of the present disclosure may result in more feasible multi-terminal components with higher compatibility with a substrate manufacturing process (e.g., forming connections with the ISCs using laser drilling) resulting in a more compact design and advantageous space savings on a substrate.

The embodiments of the present disclosure may provide the significantly advantageous features of matching an ISC thickness with a thickness of a copper wiring pattern embedded in a same build-up layer as the ISC. As a result, an ISC may be used as a filler (e.g., dummy silicon) in areas of a semiconductor package where it is not possible to form or place copper, thereby improving a mechanical strength of the semiconductor package, and also improving dielectric thickness uniformity.

The embodiments of the present disclosure may result in substrate thickness reduction. For example, a conventional semiconductor package with a ceramic capacitor requires a 500 µm thick core to allow capacitor embedding in a core layer. In contrast, the embodiments of the present disclosure have a core thickness of around 50 µm if an ISC is embedded in a build-up layer.

The embodiments have been described above and illustrated in terms of blocks, as shown in the drawings, which carry out the described function or functions. These blocks may be physically implemented by analog and/or digital circuits including one or more of a logic gate, an integrated circuit, a microprocessor, a microcontroller, a memory circuit, a passive electronic component, an active electronic component, an optical component, and the like, and may also be implemented by or driven by software and/or firmware (configured to perform the functions or operations described herein). The circuits may, for example, be embodied in one or more semiconductor chips, or on substrate supports such as printed circuit boards and the like. Circuits included in a block may be implemented by dedicated hardware, or by a processor (e.g., one or more programmed microprocessors and associated circuitry), or by a combination of dedicated hardware to perform some functions of the block and a processor to perform other functions of the block. Each block of the embodiments may be physically separated into two or more interacting and discrete blocks. Likewise, the blocks of the embodiments may be physically combined into more complex blocks.

Although the embodiments of the present disclosure are described with respect to copper, this metal is merely an example. As understood by one of ordinary skill in the art, the embodiments of the present disclosure may replace copper with other suitable materials such as aluminum (Al), tungsten (W), cobalt (C), titanium (Ti), tantalum (Ta), molybdenum (Mo), and ruthenium (Ru).

## Claims

1. A semiconductor package (100) comprising:
a core layer (202);
a capacitor (208A, 208B) on the core layer (202);
one or more build-up layers (210) on the core layer (202), wherein the capacitor (208A, 208B) is embedded in the one or more build-up layers (210); and
one or more metal layers (212A, 212B) on the core layer (202), **characterized in that**
a thickness of the capacitor (208A, 208B) is substantially equal to a thickness of the at least one metal layer (212A, 212B).

2. The semiconductor package (100) according to claim 1, wherein the one or more metal layers (212A, 212B) comprise at least one metal layer (212A, 212B) that is in contact with a surface of the core layer (202).

3. The semiconductor package (100) according to claim 2, wherein the capacitor (208A, 208B) is in contact with the at least one metal layer (212A, 212B).

4. The semiconductor package (100) according to claim 2 or 3, wherein the one or more build-up layers (210) comprise at least one build-up layer (210) that covers the capacitor (208A, 208B) and the at least one metal layer (212A, 212B).

5. The semiconductor package (100) according to any one of claims 1 to 4,
wherein a thickness of the at least one build-up layer (210) is greater than a thickness of the capacitor (208A, 208B).

6. The semiconductor package (100) according to any one of claims 1 to 5,
wherein a thickness of the at least one build-up layer (210) is greater than a combination of the thickness of the capacitor (208A, 208B) and the thickness of the at least one metal layer (212A, 212B).

7. The semiconductor package (100) according to any one of claims 1 to 6, further comprising:
N metal contacts disposed on the capacitor (208A, 208B),
wherein N is a positive integer greater than or equal to 3.

8. The semiconductor package (100) according to any one of claims 1 to 7,
wherein the one or more build-up layers (210) comprise a first build-up layer that is in contact with the core layer (202), and a second build-up layer on the first build-up layer,
wherein the capacitor (208A, 208B) is disposed on the first build-up layer before the second build-up layer is formed.

9. The semiconductor package (100) according to any one of claims 1 to 7,
wherein the capacitor (208A, 208B) is in contact with a surface of the core layer (202).

10. The semiconductor package (100) according to any one of claims 1 to 9,
wherein the capacitor (208A, 208B) is an active capacitor, and wherein the semiconductor package (100) further comprises:
a non-active capacitor that is included in a same build-up layer from the one or more build-up layers (210) as the active capacitor.

11. The semiconductor package (100) according to any one of claims 1 to 10,
wherein the one or more metal layers (212A, 212B) comprises a metal selected from the group consisting of copper, Cu, aluminum, Al, tungsten, W, cobalt, C, titanium, Ti, tantalum, Ta, molybdenum, Mo, and ruthenium, Ru.

## Patentansprüche

1. Halbleiter-Package (100), aufweisend:
einer Kernschicht (202);
einen Kondensator (208A, 208B) auf der Kernschicht (202);
eine oder mehrere Aufbauschichten (210) auf der Kernschicht (202), wobei der Kondensator (208A, 208B) in die eine oder die mehreren Aufbauschichten (210) eingebettet ist; und
eine oder mehrere Metallschichten (212A, 212B) auf der Kernschicht (202),
**dadurch gekennzeichnet, dass**
eine Dicke des Kondensators (208A, 208B) im Wesentlichen gleich einer Dicke der zumindest einen Metallschicht (212A, 212B) ist.

2. Halbleiter-Package (100) nach Anspruch 1, wobei die eine oder die mehreren Metallschichten (212A, 212B) zumindest eine Metallschicht (212A, 212B) aufweisen, welche mit einer Oberfläche der Kernschicht (202) in Kontakt steht.

3. Halbleiter-Package (100) nach Anspruch 2, wobei der Kondensator (208A, 208B) mit der zumindest einen Metallschicht (212A, 212B) in Kontakt steht.

4. Halbleiter-Package (100) nach Anspruch 2 oder 3, wobei die eine oder die mehreren Aufbauschichten (210) zumindest eine Aufbauschicht (210) aufweisen, welche den Kondensator (208A, 208B) und die zumindest eine Metallschicht (212A, 212B) bedeckt.

5. Halbleiter-Package (100) nach einem der Ansprüche 1 bis 4, wobei eine Dicke der zumindest einen Aufbauschicht (210) größer ist als eine Dicke des Kondensators (208A, 208B).

6. Halbleiter-Package (100) nach einem der Ansprüche 1 bis 5, wobei eine Dicke der zumindest einen Aufbauschicht (210) größer ist als eine Kombination aus der Dicke des Kondensators (208A, 208B) und der Dicke der zumindest einen Metallschicht (212A, 212B).

7. Halbleiter-Package (100) nach einem der Ansprüche 1 bis 6, ferner aufweisend:
N Metallkontakte, die auf dem Kondensator (208A, 208B) angeordnet sind,
wobei N eine positive Ganzzahl größer oder gleich 3 ist.

8. Halbleiter-Package (100) nach einem der Ansprüche 1 bis 7, wobei die eine oder die mehreren Aufbauschichten (210) eine erste Aufbauschicht, die mit der Kernschicht (202) in Kontakt steht, und eine zweite Aufbauschicht auf der ersten Aufbauschicht aufweisen,
wobei der Kondensator (208A, 208B) auf der ersten Aufbauschicht angeordnet wird, bevor die zweite Aufbauschicht gebildet wird.

9. Halbleiter-Package (100) nach einem der Ansprüche 1 bis 7, wobei der Kondensator (208A, 208B) mit einer Oberfläche der Kernschicht (202) in Kontakt steht.

10. Halbleiter-Package (100) nach einem der Ansprüche 1 bis 9, wobei der Kondensator (208A, 208B) ein aktiver Kondensator ist, und wobei das Halbleiter-Package (100) ferner folgende Merkmal aufweist:
einen nichtaktiven Kondensator, der in derselben Aufbauschicht von der einen oder den mehreren Aufbauschichten (210) wie der aktive Kondensator enthalten ist.

11. Halbleiter-Package (100) nach einem der Ansprüche 1 bis 10, wobei die eine oder die mehreren Metallschichten (212A, 212B) ein Metall aufweisen, das aus der Gruppe bestehend aus Kupfer, Cu, Aluminium, Al, Wolfram, W, Kobalt, C, Titan, Ti, Tantal, Ta, Molybdän, Mo, und Ruthenium, Ru, ausgewählt ist.

## Revendications

1. . Boîtier semi-conducteur (100) comprenant :
une couche cœur (202) ;
un condensateur (208A, 208B) sur la couche cœur (202) ;
une ou plusieurs couches d'empilement (210) sur la couche cœur (202), le condensateur (208A, 208B) étant incorporé dans lesdites une ou plusieurs couches d'empilement (210) ; et
une ou plusieurs couches métalliques (212A, 212B) sur la couche cœur (202), **caractérisé en ce que**
une épaisseur du condensateur (208A, 208B) est sensiblement égale à une épaisseur de ladite au moins une couche métallique (212A, 212B).

2. . Boîtier semi-conducteur (100) selon la revendication 1, dans lequel lesdites une ou plusieurs couches métalliques (212A, 212B) comprennent au moins une couche métallique (212A, 212B) qui est en contact avec une surface de la couche cœur (202).

3. . Boîtier semi-conducteur (100) selon la revendication 2, dans lequel le condensateur (208A, 208B) est en contact avec ladite au moins une couche métallique (212A, 212B).

4. . Boîtier semi-conducteur (100) selon la revendication 2 ou 3, dans lequel lesdites une ou plusieurs couches d'empilement (210) comprennent au moins une couche d'empilement (210) qui recouvre le condensateur (208A, 208B) et ladite au moins une couche métallique (212A, 212B).

5. . Boîtier semi-conducteur (100) selon l'une quelconque des revendications 1 à 4, dans lequel une épaisseur de ladite au moins une couche d'empilement (210) est supérieure à une épaisseur du condensateur (208A, 208B).

6. . Boîtier semi-conducteur (100) selon l'une quelconque des revendications 1 à 5, dans lequel une épaisseur de ladite au moins une couche d'empilement (210) est supérieure à une combinaison de l'épaisseur du condensateur (208A, 208B) et de l'épaisseur de ladite au moins une couche métallique (212A, 212B).

7. . Boîtier semi-conducteur (100) selon l'une quelconque des revendications 1 à 6, comprenant en outre :
N contacts métalliques disposés sur le condensateur (208A, 208B),
N étant un entier positif supérieur ou égal à 3.

8. . Boîtier semi-conducteur (100) selon l'une quelconque des revendications 1 à 7, dans lequel lesdites une ou plusieurs couches d'empilement (210) comprennent une première couche d'empilement qui est en contact avec la couche cœur (202), et une deuxième couche d'empilement sur la première couche d'empilement, le condensateur (208A, 208B) étant disposé sur la première couche d'empilement avant que la deuxième couche d'empilement ne soit formée.

9. . Boîtier semi-conducteur (100) selon l'une quelconque des revendications 1 à 7, dans lequel le condensateur (208A, 208B) est en contact avec une surface de la couche cœur (202).

10. . Boîtier semi-conducteur (100) selon l'une quelconque des revendications 1 à 9, dans lequel le condensateur (208A, 208B) est un condensateur actif, et dans lequel le boîtier semi-conducteur (100) comprend en outre :
un condensateur non actif qui est inclus dans une même couche d'empilement, parmi lesdites une ou plusieurs couches d'empilement (210), que le condensateur actif.

11. . Boîtier semi-conducteur (100) selon l'une quelconque des revendications 1 à 10, dans lequel lesdites une ou plusieurs couches métalliques (212A, 212B) comprennent un métal choisi dans le groupe constitué par le cuivre, Cu, l'aluminium, Al, le tungstène, W, le cobalt, Co, le titane, Ti, le tantale, Ta, le molybdène, Mo, et le ruthénium, Ru.
